# EUROPEAN PATENT APPLICATION

(11) **EP 4 712 121 A1**
(43) Date of publication of application: **18.03.2026**
(21) Application number: 25202131.6
(22) Date of filing: 15.09.2025
(51) Int. Cl.: H01H 1/00, H01H 9/16, H01H 11/00, H01H 47/00, G01R 31/327

(54) **CONTACTOR DETECTION CIRCUIT**

(30) Priority: 13.09.2024 CN 202411291252
(71) Applicant: Tyco Electronics (Shanghai) Co., Ltd., Pilot Free Trade Zone Shanghai 200131 (CN)
(72) Inventor: Wang, Jimmy, Shanghai, 200233 (CN); Mao, Xinhui, Shanghai, 200233 (CN); Wu, Yisong, Shanghai, 200233 (CN); An, Hang, Shenzhen, 215321 (CN); Liu, Xuejun, Shanghai, 200233 (CN)
(74) Representative: Grünecker Patent- und Rechtsanwälte PartG mbB

(57) **Abstract**

The present invention discloses a contactor detection circuit. The contactor detection circuit comprises: a comparator; a reference voltage generation circuit, whose output end is connected to the inverting input end of the comparator, for inputting a reference voltage V1 to the inverting input end of the comparator; a sampling circuit electrically connected to two static contacts of a contactor and its output end connected to the in-phase input end of the comparator, for inputting a sampling voltage V2 to the in-phase input end of the comparator; and a waveform generator, whose output end is connected to the input end of the sampling circuit, is used to input a periodically changing voltage signal V3 to the sampling circuit. When the contactor is in an open state, the sampling voltage V2 output by the sampling circuit is a periodic waveform, causing the comparator to output a periodic square wave signal; when the contactor is in a closed state, the sampling voltage V2 output by the sampling circuit is higher than the reference voltage V1, causing the comparator to output a high level. The present invention does not require the use of isolated power supplies and isolated operational amplifiers, nor does it require the use of MCUs or the development of specialized software, greatly reducing costs.

## Description

### BACKGROUND OF THE INVENTION

### Field of the Invention

The present invention relates to a contactor detection circuit.

### Description of the Related Art

High voltage contactors are important components of high-voltage distribution systems, and the status detection of contactors is a crucial safety function. There are currently two main detection schemes for contactors. One method is to use a high-voltage source as the sampling input and determine the status of the contactor through voltage division sampling. The disadvantage of the first solution is that it requires isolation of the power supply and isolation of the operational amplifier to achieve high and low voltage isolation, which is costly. In addition, the first approach relies on a high-voltage source as the sampling input and requires real-time knowledge of the high-voltage voltage, which is inconvenient for practical applications. The second solution is to use PWM waves generated by a microcontroller unit (MCU) to achieve high and low voltage isolation through a Y capacitor. The disadvantage of the second solution is that it requires MCU and software development, resulting in higher costs.

### SUMMARY OF THE INVENTION

The present invention has been made to overcome or alleviate at least one aspect of the above mentioned disadvantages.

According to an aspect of the present invention, there is provided a contactor detection circuit. The contactor detection circuit comprises: a comparator; a reference voltage generation circuit, whose output end is connected to the inverting input end of the comparator, for inputting a reference voltage V1 to the inverting input end of the comparator; a sampling circuit electrically connected to two static contacts of a contactor and its output end connected to the in-phase input end of the comparator, for inputting a sampling voltage V2 to the in-phase input end of the comparator; and a waveform generator, whose output end is connected to the input end of the sampling circuit, is used to input a periodically changing voltage signal V3 to the sampling circuit. When the contactor is in an open state, the sampling voltage V2 output by the sampling circuit is a periodic waveform, causing the comparator to output a periodic square wave signal; when the contactor is in a closed state, the sampling voltage V2 output by the sampling circuit is higher than the reference voltage V1, causing the comparator to output a high level.

According to an exemplary embodiment of the present invention, the sampling circuit comprises: a capacitor C1, one end of which is used to connect with a static contact of the contactor; a resistance R1, with one end grounded and the other end connected to the other end of capacitor C1; a capacitor C2, one end of which is used to connect with the other static contact of the contactor; and a resistor R2, one end of which is connected to the output end of the waveform generator, the other end of which is connected to the other end of the capacitor C2 and the in-phase input end of the comparator. One end of the resistor R2 serves as the input end of the sampling circuit, and the other end of the resistor R2 serves as the output end of the sampling circuit.

According to another exemplary embodiment of the present invention, the capacitors C1 and C2 are Y capacitors used for electrically isolating the high-voltage circuit connected to the two static contacts of the contactor.

According to another exemplary embodiment of the present invention, the sampling circuit further comprises: a diode D1, with its positive end connected to the other end of resistor R2 and the other end of capacitor C2, and its negative end connected to the in-phase input end of comparator.

According to another exemplary embodiment of the present invention, when the contactor is in the open state, the sampling circuit is in an open circuit state, and the sampling voltage V2 output by the sampling circuit is the output of the waveform generator minus the forward voltage drop of the diode D1.

According to another exemplary embodiment of the present invention, when the contactor is in the closed state, one end of the capacitor C1 is electrically connected to one end of the capacitor C2, the output of the waveform generator is divided by the resistor R1 and the capacitor C1, and the resistor R2 and the capacitor C2, so that the sampling voltage V2 output by the sampling circuit is equal to the total voltage across the resistor R1, the capacitor C1, and the capacitor C2.

According to another exemplary embodiment of the present invention, the periodic voltage signal V3 output by the waveform generator is a waveform signal with a predetermined frequency, and the waveform signal is a square wave signal, a triangular wave signal, or a sine wave signal.

According to another exemplary embodiment of the present invention, the amplitude of the waveform signal is 2.5V and the waveform signal is forward biased by 2.5V, causing the waveform signal to periodically vary between 0V and 5V.

According to another exemplary embodiment of the present invention, the contactor detection circuit further comprises a LDO circuit which has an input end for electrical connection to a power supply, the output end of the LDO circuit is connected to the power supply ends of the comparator, the reference voltage generation circuit, and the waveform generator, for supplying power to the comparator, the reference voltage generation circuit, and the waveform generator.

According to another exemplary embodiment of the present invention, the contactor detection circuit further comprises a power supply connected to the input end of the LDO circuit, the output voltage of the power supply is 6-18V, and the output voltage of the LDO circuit is equal to 5V.

According to another exemplary embodiment of the present invention, the reference voltage generation circuit comprises: a resistor R4, one end of which is connected to the output end of the LDO circuit; and a resistor R5, one end of which is connected to the other end of resistor R4 and the inverting input of comparator. The other end of resistor R5 is grounded, and the reference voltage V1 at the inverting input of comparator is equal to the voltage across resistor R5.

According to another exemplary embodiment of the present invention, the output end of the comparator is used to connect with an input end of an analog-to-digital converter of an electronic control unit, in order to input an analog detection voltage V4 to the analog-to-digital converter of the electronic control unit.

According to another exemplary embodiment of the present invention, the contactor detection circuit further comprises a voltage divider circuit, connected to the output end of the comparator and the input end of the analog-to-digital converter of the electronic control unit, is used to divide the output of the comparator so that the analog detection voltage V4 input to the analog-to-digital converter is equal to a predetermined value.

According to another exemplary embodiment of the present invention, the voltage divider circuit comprises: a resistor R6, one end of which is connected to the output end of the comparator, and the other end is used for electrical connection to the input end of the analog-to-digital converter; and a resistor R7, one end of which is connected to the other end of resistor R6. The other end of resistor R7 is grounded, and the analog detection voltage V4 input to the input end of the analog-to-digital converter is equal to the voltage across resistor R7.

According to another exemplary embodiment of the present invention, when the contactor is in the open state, the voltage on the resistor R7 is a periodic square wave signal, so that the analog detection voltage V4 input to the input end of the analog-to-digital converter is a periodic square wave signal; when the contactor is in the closed state, the voltage on the resistor R7 is equal to 2V, so that the analog detection voltage V4 input to the input end of the analog-to-digital converter is equal to 2V.

In the aforementioned exemplary embodiments according to the present invention, there is no need to use isolated power supplies and isolated operational amplifiers, and there is no need to use MCUs or develop dedicated software, greatly reducing costs.

### BRIEF DESCRIPTION OF THE DRAWINGS

The above and other features of the present invention will become more apparent by describing in detail exemplary embodiments thereof with reference to the accompanying drawings, in which:
Figure 1 shows a circuit diagram of a contactor detection circuit according to an exemplary embodiment of the present invention, wherein the contactor is in an open state;
Figure 2 shows a circuit diagram of a contactor detection circuit according to an exemplary embodiment of the present invention, wherein the contactor is in a closed state; and
Figure 3 shows a circuit diagram of a contactor detection circuit according to an exemplary embodiment of the present invention, wherein the numerical values of each electrical component are indicated.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a contactor detection circuit. The contactor detection circuit comprises: a comparator; a reference voltage generation circuit, whose output end is connected to the inverting input end of the comparator, for inputting a reference voltage V1 to the inverting input end of the comparator; a sampling circuit electrically connected to two static contacts of a contactor and its output end connected to the in-phase input end of the comparator, for inputting a sampling voltage V2 to the in-phase input end of the comparator; and a waveform generator, whose output end is connected to the input end of the sampling circuit, is used to input a periodically changing voltage signal V3 to the sampling circuit. When the contactor is in an open state, the sampling voltage V2 output by the sampling circuit is a periodic waveform, causing the comparator to output a periodic square wave signal; when the contactor is in a closed state, the sampling voltage V2 output by the sampling circuit is higher than the reference voltage V1, causing the comparator to output a high level.

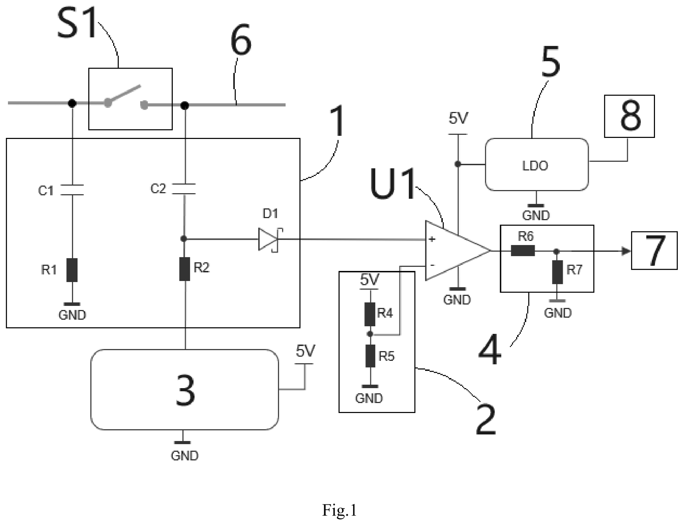

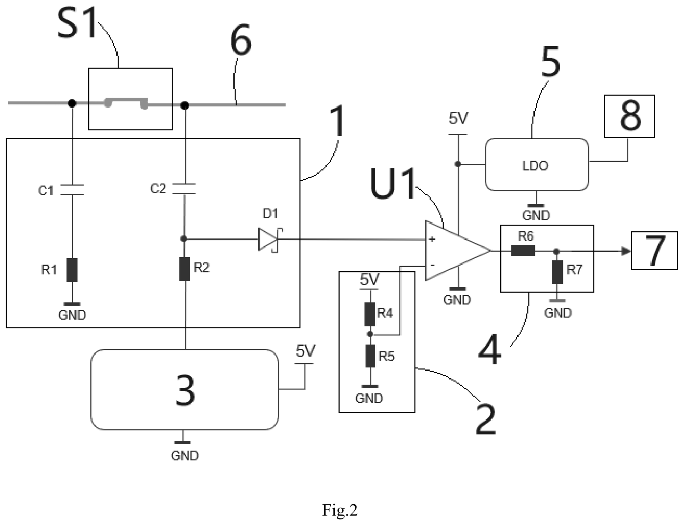

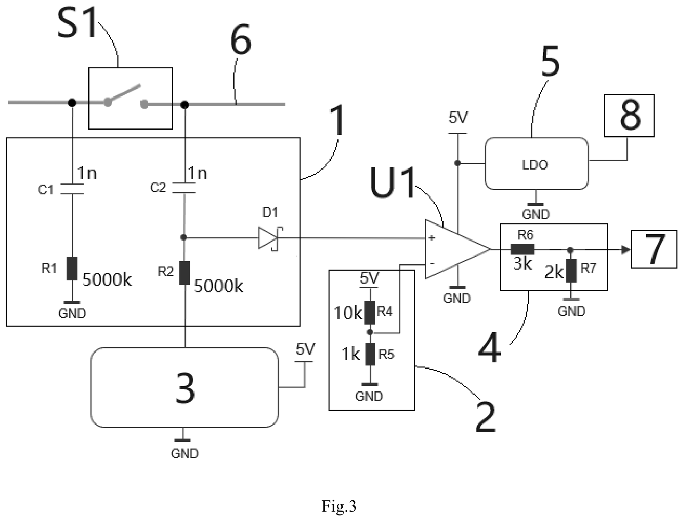

Figure 1 shows a circuit diagram of a contactor detection circuit according to an exemplary embodiment of the present invention, wherein the contactor is in an open state; Figure 2 shows a circuit diagram of a contactor detection circuit according to an exemplary embodiment of the present invention, wherein the contactor is in a closed state; Figure 3 shows a circuit diagram of a contactor detection circuit according to an exemplary embodiment of the present invention, where the numerical values of each electrical component are indicated.

As shown in Figures 1 to 3, in an exemplary embodiment of the present invention, a contactor detection circuit is disclosed. The contactor detection circuit includes: a comparator U1, a reference voltage generation circuit 2, a sampling circuit 1, and a waveform generator 3. The output end of reference voltage generation circuit 2 is connected to the inverting input end of comparator U1, for inputting reference voltage V1 to the inverting input end of comparator U1. Sampling circuit 1 is electrically connected to the two static contacts of contactor S1 and its output end is connected to the in-phase input end of comparator U1, for inputting sampling voltage V2 to the in-phase input end of comparator U1. The output end of waveform generator 3 is connected to the input end of sampling circuit 1, for inputting periodic voltage signal V3 to sampling circuit 1.

As shown in Figures 1 to 3, in the illustrated embodiment, when the contactor S1 is in the open state, the sampling voltage V2 output by the sampling circuit 1 is a periodic waveform, which causes the comparator U1 to output a periodic square wave signal. When contactor S1 is in the closed state, the sampling voltage V2 output by sampling circuit 1 is higher than the reference voltage V1, which causes comparator U1 to output a high level. Therefore, in the present invention, the state of contactor S1 can be determined based on the output of comparator U1. When comparator U1 outputs a periodic square wave signal, it can be determined that contactor S1 is in an open state. When comparator U1 outputs a high level, it can be determined that contactor S1 is in a closed state.

As shown in Figures 1 to 3, in the illustrated embodiment, the sampling circuit 1 includes a capacitor C1, a resistor R1, a capacitor C2, and a resistor R2. One end of the capacitor C1 is used to connect with one static contact of the contactor S1 (i.e., one static contact point of the contactor). One end of resistor R1 is grounded, and the other end is connected to the other end of capacitor C1. One end of capacitor C2 is used to connect with the other static contact of contactor S1 (i.e. the other static contact point of the contactor). One end of resistor R2 is connected to the output end of waveform generator 3, and the other end is connected to the other end of capacitor C2 and the in-phase input end of comparator U1. In the illustrated embodiment, one end of resistor R2 serves as the input end of sampling circuit 1, and the other end of resistor R2 serves as the output end of sampling circuit 1.

As shown in Figures 1 to 3, in the illustrated embodiment, capacitors C1 and C2 are Y capacitors used for electrically isolating the high-voltage circuit 6 connected to the two static contacts of contactor S1. In this way, high and low voltage isolation can be reliably achieved, improving the safety of use.

As shown in Figures 1 to 3, in the illustrated embodiment, the sampling circuit 1 further includes a diode D1. The positive end of diode D1 is connected to the other end of resistor R2 and the other end of capacitor C2, and the negative end of diode D1 is connected to the in-phase input end of comparator U1.

As shown in Figures 1 to 3, in the illustrated embodiment, when the contactor S1 is in the open state, the sampling circuit 1 is in the open state, and the voltage drop of the resistor R2 is almost zero, so that the sampling voltage V2 output by the sampling circuit 1 is equal to the output of the waveform generator 3 minus the forward voltage drop of the diode D1. At this time, the sampling voltage V2 output by the sampling circuit 1 is the periodic voltage signal V3 minus the forward voltage drop of the diode D1.

As shown in Figures 1 to 3, in the illustrated embodiment, when contactor S1 is in a closed state, one end of capacitor C1 is electrically connected to one end of capacitor C2. The output of waveform generator 3 is divided by resistor R1 and capacitor C1, resistor R2 and capacitor C2, so that the sampling voltage V2 output by sampling circuit 1 is equal to the total voltage across resistor R1, capacitor C1 and capacitor C2.

As shown in Figures 1 to 3, in the illustrated embodiment, the periodic voltage signal V3 output by the waveform generator 3 is a waveform signal with a predetermined frequency, and the waveform signal can be a square wave signal, a triangular wave signal, a sine wave signal, or other suitable waveform signal.

As shown in Figures 1 to 3, in the illustrated embodiment, the amplitude of the waveform signal is 2.5V and the waveform signal is forward biased by 2.5V, causing the waveform signal to periodically vary between 0V and 5V.

As shown in Figures 1 to 3, in the illustrated embodiment, the contactor detection circuit further includes an LDO (Low dropout regulator) circuit 5. The input end of LDO circuit 5 is used for electrical connection to power supply 8. The output end of LDO circuit 5 is connected to the power supply ends of comparator U1, reference voltage generation circuit 2, and waveform generator 3, used to supply power to comparator U1, reference voltage generation circuit 2, and waveform generator 3. In the illustrated embodiment, LDO circuit 5 can provide a stable 5V voltage to comparator U1, reference voltage generation circuit 2, and waveform generator 3.

As shown in Figures 1 to 3, in the illustrated embodiment, the contactor detection circuit further includes a power supply 8, which is connected to the input end of the LDO circuit 5. The output voltage of power supply 8 is 6-18V, and the output voltage of LDO circuit 5 is equal to 5V. The output voltage of power supply 8 can fluctuate between 6-18V, but LDO circuit 5 can ensure that its output voltage is always equal to 5V.

As shown in Figures 1 to 3, in the illustrated embodiment, the reference voltage generation circuit 2 includes a resistor R4 and a resistor R5. One end of the resistor R4 is connected to the output end of the LDO circuit 5. One end of resistor R5 is connected to the other end of resistor R4 and the inverting input of comparator U1. The other end of resistor R5 is grounded, and the reference voltage V1 at the inverting input of comparator U1 is equal to the voltage across resistor R5.

As shown in Figures 1 to 3, in the illustrated embodiment, the output end of comparator U1 is used to connect with the input end of analog-to-digital converter 7 of the electronic control unit, in order to input analog detection voltage V4 to the analog-to-digital converter 7 of the electronic control unit.

As shown in Figures 1 to 3, in the illustrated embodiment, the contactor detection circuit further includes a voltage divider circuit 4, which is connected to the output end of the comparator U1 and the input end of the analog-to-digital converter 7 of the electronic control unit, for dividing the output of the comparator U1, so that the analog detection voltage V4 input to the analog-to-digital converter 7 is equal to a predetermined value. In the illustrated embodiment, the simulated detection voltage V4 is equal to 2V.

As shown in Figures 1 to 3, in the illustrated embodiment, the voltage divider circuit 4 includes a resistor R6 and a resistor R7. One end of the resistor R6 is connected to the output end of the comparator U1, and the other end is used for electrical connection to the input end of the analog-to-digital converter 7. One end of resistor R7 is connected to the other end of resistor R6. The other end of resistor R7 is grounded, and the analog detection voltage V4 at the input of analog-to-digital converter 7 is equal to the voltage across resistor R7.

As shown in Figures 1 to 3, in the illustrated embodiment, when the contactor S1 is in the open state, the voltage on the resistor R7 is a periodic square wave signal, so that the analog detection voltage V4 at the input end of the analog-to-digital converter 7 is a periodic square wave signal. When contactor S1 is in the closed state, the voltage across resistor R7 is equal to 2V, causing the analog detection voltage V4 at the input of analog-to-digital converter 7 to be equal to 2V. Therefore, in the illustrated embodiment, the state of contactor S1 can be determined based on the analog detection voltage V4. When the simulated detection voltage V4 is a periodic square wave signal, it can be determined that the contactor S1 is in the open state. When the simulated detection voltage V4 is equal to 2V, it can be determined that the contactor S1 is in a closed state.

Figure 3 shows the specific numerical values of each electronic component in the contactor detection circuit. However, the present invention is not limited to the illustrated embodiment, and the specific numerical values of each electronic component in the contactor detection circuit can be adjusted according to the actual situation.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A contactor detection circuit, comprising:
a comparator (U1);
a reference voltage generation circuit (2), whose output end is connected to the inverting input end of the comparator (U1), for inputting a reference voltage V1 to the inverting input end of the comparator (U1);
a sampling circuit (1) electrically connected to two static contacts of a contactor (S1) and its output end connected to the in-phase input end of the comparator (U1), for inputting a sampling voltage V2 to the in-phase input end of the comparator (U1); and
a waveform generator (3), whose output end is connected to the input end of the sampling circuit (1), is used to input a periodically changing voltage signal V3 to the sampling circuit (1),
wherein when the contactor (S1) is in an open state, the sampling voltage V2 output by the sampling circuit (1) is a periodic waveform, causing the comparator (U1) to output a periodic square wave signal,
wherein when the contactor (S1) is in a closed state, the sampling voltage V2 output by the sampling circuit (1) is higher than the reference voltage V1, causing the comparator (U1) to output a high level.

2. The contactor detection circuit according to claim 1,
wherein the sampling circuit (1) comprises:
a capacitor C1, one end of which is used to connect with a static contact of the contactor (S1);
a resistance R1, with one end grounded and the other end connected to the other end of capacitor C1;
a capacitor C2, one end of which is used to connect with the other static contact of the contactor (S1); and
a resistor R2, one end of which is connected to the output end of the waveform generator (3), the other end of which is connected to the other end of the capacitor C2 and the in-phase input end of the comparator (U1),
wherein one end of the resistor R2 serves as the input end of the sampling circuit (1), and the other end of the resistor R2 serves as the output end of the sampling circuit (1).

3. The contactor detection circuit according to claim 2,
wherein the capacitors C1 and C2 are Y capacitors used for electrically isolating the high-voltage circuit (6) connected to the two static contacts of the contactor (S1).

4. The contactor detection circuit according to claim 2,
wherein the sampling circuit (1) further comprises:
a diode D1, with its positive end connected to the other end of resistor R2 and the other end of capacitor C2, and its negative end connected to the in-phase input end of comparator (U1).

5. The contactor detection circuit according to claim 4,
wherein when the contactor (S1) is in the open state, the sampling circuit (1) is in an open circuit state, and the sampling voltage V2 output by the sampling circuit (1) is the output of the waveform generator (3) minus the forward voltage drop of the diode D1.

6. The contactor detection circuit according to claim 2,
wherein when the contactor (S1) is in the closed state, one end of the capacitor C1 is electrically connected to one end of the capacitor C2, the output of the waveform generator (3) is divided by the resistor R1 and the capacitor C1, and the resistor R2 and the capacitor C2, so that the sampling voltage V2 output by the sampling circuit (1) is equal to the total voltage across the resistor R1, the capacitor C1, and the capacitor C2.

7. The contactor detection circuit according to claim 1,
wherein the periodic voltage signal V3 output by the waveform generator (3) is a waveform signal with a predetermined frequency, and the waveform signal is a square wave signal, a triangular wave signal, or a sine wave signal.

8. The contactor detection circuit according to claim 7,
wherein the amplitude of the waveform signal is 2.5V and the waveform signal is forward biased by 2.5V, causing the waveform signal to periodically vary between 0V and 5V.

9. The contactor detection circuit according to claim 1, further comprising:
a LDO circuit (5) which has an input end for electrical connection to a power supply (8),
wherein the output end of the LDO circuit (5) is connected to the power supply ends of the comparator (U1), the reference voltage generation circuit (2), and the waveform generator (3), for supplying power to the comparator (U1), the reference voltage generation circuit (2), and the waveform generator (3).

10. The contactor detection circuit according to claim 9, further comprising:
a power supply (8) connected to the input end of the LDO circuit (5),
wherein the output voltage of the power supply (8) is 6-18V, and the output voltage of the LDO circuit (5) is equal to 5V.

11. The contactor detection circuit according to claim 9,
wherein the reference voltage generation circuit (2) comprises:
a resistor R4, one end of which is connected to the output end of the LDO circuit (5); and
a resistor R5, one end of which is connected to the other end of resistor R4 and the inverting input of comparator (U1),
wherein the other end of resistor R5 is grounded, and the reference voltage V1 at the inverting input of comparator (U1) is equal to the voltage across resistor R5.

12. The contactor detection circuit according to any one of claims 1-11,
wherein the output end of the comparator (U1) is used to connect with an input end of an analog-to-digital converter (7) of an electronic control unit, in order to input an analog detection voltage V4 to the analog-to-digital converter (7) of the electronic control unit.

13. The contactor detection circuit according to claim 12, further comprising:
a voltage divider circuit (4), connected to the output end of the comparator (U1) and the input end of the analog-to-digital converter (7) of the electronic control unit, is used to divide the output of the comparator (U1) so that the analog detection voltage V4 input to the analog-to-digital converter (7) is equal to a predetermined value.

14. The contactor detection circuit according to claim 13,
wherein the voltage divider circuit (4) comprises:
a resistor R6, one end of which is connected to the output end of the comparator (U1), and the other end is used for electrical connection to the input end of the analog-to-digital converter (7); and
a resistor R7, one end of which is connected to the other end of resistor R6,
wherein the other end of resistor R7 is grounded, and the analog detection voltage V4 input to the input end of the analog-to-digital converter (7) is equal to the voltage across resistor R7.

15. The contactor detection circuit according to claim 14,
wherein when the contactor (S1) is in the open state, the voltage on the resistor R7 is a periodic square wave signal, so that the analog detection voltage V4 input to the input end of the analog-to-digital converter (7) is a periodic square wave signal;
wherein when the contactor (S1) is in the closed state, the voltage on the resistor R7 is equal to 2V, so that the analog detection voltage V4 input to the input end of the analog-to-digital converter (7) is equal to 2V.
